Europäisches Patentamt

European Patent Office

Office européen des brevets

(11) Publication number: **0 110 632**
**B1**

# EUROPEAN PATENT SPECIFICATION

(45) Date of publication of patent specification: **18.03.87**

(51) Int. Cl.⁴: **B 41 J 29/00, H 05 K 7/00**

(21) Application number: **83307031.1**

(22) Date of filing: **17.11.83**

(54) **Auxiliary memory module for an electronic typewriter.**

(30) Priority: **18.11.82 IT 5396182 u**

(43) Date of publication of application:
**13.06.84 Bulletin 84/24**

(45) Publication of the grant of the patent:
**18.03.87 Bulletin 87/12**

(84) Designated Contracting States:
**DE FR GB**

(56) References cited:
**EP-A-0 042 206**
**GB-A-2 000 381**

(73) Proprietor: **Ing. C. Olivetti & C., S.p.a.**
**Via G. Jervis 77**
**I-10015 Ivrea (IT)**

(72) Inventor: **Bertina, Sergio**
**Via del Rosario 25**
**I-10010 Parella (Turin) (IT)**
Inventor: **Decker, Giorgio**
**Via Omegna 16**
**I-10100 Turin (IT)**

(74) Representative: **Pears, David Ashley et al**
**REDDIE & GROSE 16 Theobalds Road**
**London WC1X 8PL (GB)**

Courier Press, Leamington Spa, England.

## Description

The present invention relates to an auxiliary memory module for an electronic typewriter, as set forth in the introductory part of claim 1.

Some current electronic typewriters have auxiliary memories where standard phrases, decoding codes, program instructions and so on are recorded. Normally, such memories comprise magnetic supports such as discs or tapes which, in order for them to be read, require a suitable piece of equipment which is added to the typewriter.

A module according to the introductory part of claim 1 is known from GB 2 000 381 and EP 0 042 206. Both references describe cassettes containing read only memory, which is inherently safe from corruption but can only hold fixed data. The object of the present invention is to make it possible to employ read-write memory which is rendered non-volatile and is furthermore protected against corruption even if the module is inserted or removed while the power is switched on.

This object is met by the module defined in the characterising part of claim 1.

The electronic circuitry of the typewriter may be supplied with a voltage which is different from and higher than that of the back-up battery. If the operation of inserting the module is performed when the machine is switched off, there is no risk of involuntarily losing some information, which could occur if ever the electrical terminals intended for data transfer between the machine and the module were to come into contact with each other before the terminals intended for the higher voltage power supply to the cassette. This possibility is excluded by the present invention, so that it is also possible for the cassette to be inserted even when the machine is switched on and thus the associated circuitry is powered.

The invention will be described in more detail, by way of example, with reference to the accompanying drawings, in which:

Figure 1 is a view from the left-hand side and in partial section of an electronic typewriter which is fitted with an auxiliary memory module according to the present invention,

Figure 2 is a view from the left-hand side and on an enlarged scale and in partial section of a memory module in cassette form and of the arrangement for connecting same to the circuitry of the machine, and

Figure 3 is a view in section taken along line 3—3 in Figure 2.

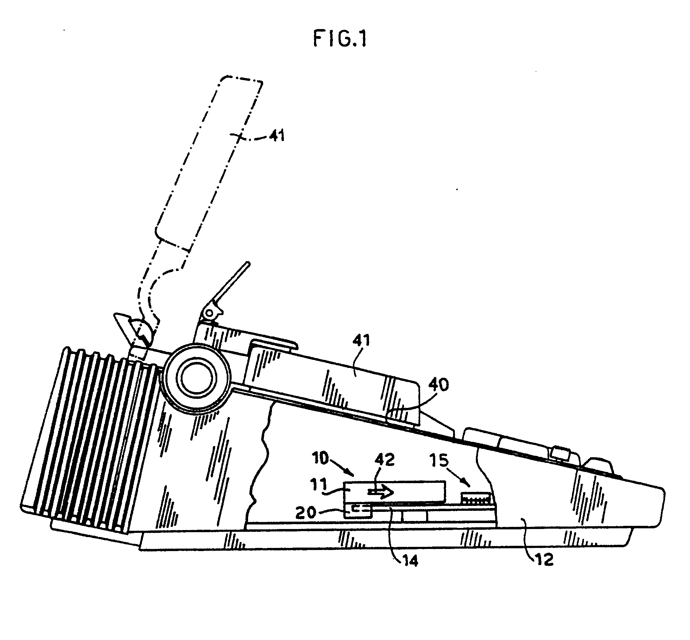

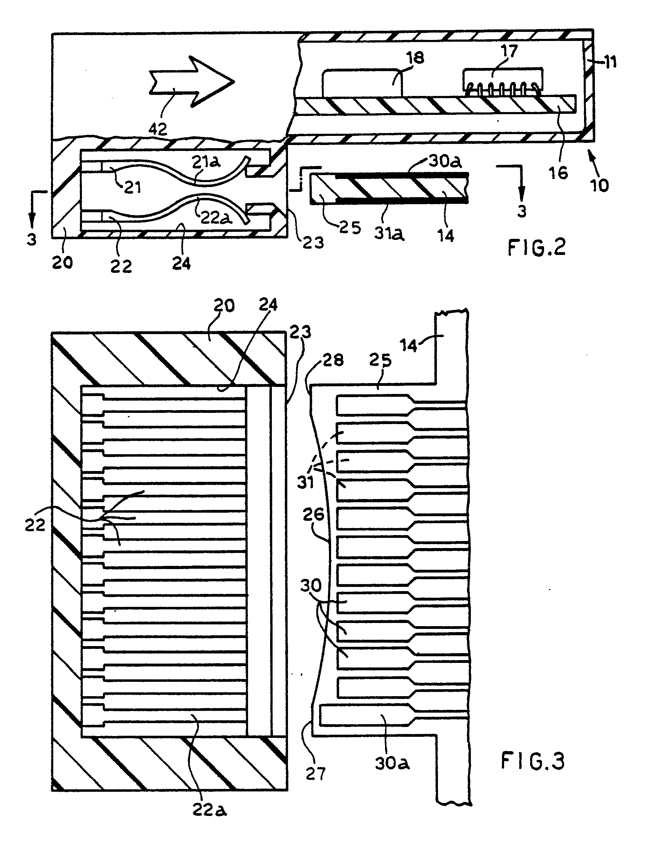

Referring to Figures 1 and 2, an auxiliary memory module 10 is contained in a cassette 11 and is capable of being removably inserted inside an electronic typewriter 12 of known type. In particular, the machine 12 comprises a board 14 of insulating material, which acts as a support for the electronic circuitry 15 which is not shown in detail and which is powered by a voltage of 5 volts.

The cassette 11 is of plastics material and is of substantially parallelepipedal shape and houses a board 16 of insulating material on which are disposed one or more memories 17 containing data and programs, being rendered non-volatile by a back-up battery 18 which generates a voltage of 2.5 volts which keeps the memories 17 energised when the cassette 11 is removed.

In its lower position, the cassette 11 comprises a connector 20 which is also of parallelepipedal shape and which is provided with a cavity 24 within which is disposed a plurality of pairs of electrical terminals 21 and 22 formed by flexible metal blades. Two lateral terminals 21a and 22a (see Figures 2 and 3) are intended for the power supply for the memories 17 when the cassette is fitted into the machine 12, while the other terminals are provided for exchange of data to and from the memories 17. All the pairs of terminals 21 and 22 are aligned and perpendicular to a front edge 23 of the connector 20.

The arrangement for connecting the cassette 11 to the circuitry 15 of the board 14 comprises a projecting portion 25 of the board 14, which has a concave edge 26, such as to define two lateral protrusions 27 and 28. Arranged on the projecting portion 25 and on both the surfaces of the board 14 is a plurality of electrical terminals 30 and 31 which are capable of co-operating with the corresponding electrical terminals 21 and 22 of the connector 20.

Two lateral terminals 30a and 31a which are arranged in line with the lateral protrusion 27 project further than the other terminals. They are connected to the 5 volts power supply of the fixed circuitry of the machine 12 and are arranged to co-operate with the terminals 21a and 22a.

The cassette 11 is fitted into the inside of the machine 12 through an upper opening 40 after a cover or lid 41 has been raised and moved into the inside of the machine 12 through an upper opening 40 after a cover or lid 41 has been raised and moved into the position shown in chain-dotted lines in Figure 1. The connection between the cassette 11 and the board 14 is made by pushing the cassette towards the front part of the machine (towards the right in Figure 1), as indicated by the arrow 42.

The projecting portion 25 of the board 14 will be fitted into the cavity defined by the connector 20 and the flexible terminals 21 and 22 will come into contact with the corresponding fixed terminals 30 and 31.

In particular, the cassette fitting operation can be performed even with the machine 12 switched on, without running the risk of losing the information stored in the memories 17. Thus, the first two fixed terminals which are contacted by the flexible terminals are the lateral terminals 30a and 31a and the voltage for supplying the memories 17 contained in the cassette 11 becomes that of the general circuitry, that is to say, 5 volts, before the other fixed terminals which are provided for data transfer can be contacted by the terminals of the connector 20. When the cassette 11 is disconnected from the board 14, the lines for data transfer is interrupted first, followed by the power supply lines.

The concave configuration of the edge 26 facilitates connecting the cassette 11 and the board 14 together. The reaction of the terminals 21, which has to be overcome during the critical phase of fitting the cassette 11 in position, is symmetrical and limited to the lateral terminals and increases uniformly by virtue of the effect of the central terminals, as the operation of inserting the cassette progresses.

Among possible modifications, the connector 20 may be fixed to the board 14 of the machine and a board similar to the projecting portion 25 may be fixed to the cassette 11 and act as a support for the printed circuit of the module and the memory components thereof.

### Claims

1. An auxiliary memory module for an electronic typewriter, comprising a support cassette (11) within which is disposed an electronic circuit comprising at least one memory element (17) and electrical connecting means (20) for connecting the memory to the fixed circuitry of the machine, wherein the electrical connecting means comprise a first connector element (20) which has a plurality of first electrical terminals (21, 22) and is fixed to the cassette and a second connector element (25) which has a plurality of second electrical terminals (30, 31) and is fixed to the circuitry of the machine, characterised in that the memory element (17) is a static memory for data and programs of the typewriter which is rendered non-volatile by a back-up battery (18) within said cassette, in that the electrical terminals of the cassette (11) comprise a plurality of pairs of opposed, spaced conductive springs (21, 22) all recessed within a cavity (24) in the cassette and extending towards the opening of the cavity, the springs having aligned free contact ends, in that the second connector element (25) comprises a projecting portion (25) of a printed circuit board (14) on which the circuitry of the typewriter is mounted, the projecting portion (25) having a concave front edge (26) flanked by two lateral protrusions (27, 28) which facilitate inserting the projecting portion (25) into the connector cavity (24) and enter before an intermediate section of the projecting portion, the second electrical terminals comprising a group of data transfer terminals (30, 31) for data transfer to and from the memory (17) and a pair of power supply terminals (30a, 31a) for the power supply for the memory when the cassette (11) is fitted in the typewriter, each of the terminals (30, 31; 30a, 31a) being so arranged on the projecting portion (25) that it can be contacted by a corresponding spring (21, 22) when the projecting portion (25) is being inserted between the pairs of springs, in that the data transfer terminals at their forward ends are aligned with each other, and in that the pair of power supply terminals (30a, 31a) are supported by one of the lateral protrusions (27) and project more than the data transfer terminals, for making connection before the connection of the data transfer terminals during insertion of the cassette.

2. A memory module according to claim 1, characterised in that the electronic circuitry of the typewriter is supplied with a voltage which is higher than the voltage of the back-up battery (18).

3. A memory module according to claim 1 or 2, characterised in that the cavity (24) enclosing all the terminals (21, 22, 21a, 22a) of cassette (11) is defined by a parallelepipedal portion lying, in use below a main container of the cassette.

### Patentansprüche

1. Hilfsspeichermodul für eine elektronische Schreibmaschine, mit einer Trägerkassette (11), in der eine elektronische Schaltung angeordnet ist, die wenigstens ein Speicherelement (17) und elektrische Verbindungsmittel (20) zum Verbinden des Speichers mit der feststehenden Schaltungsanordnung der Maschine aufweist, wobei die elektrischen Verbindungsmittel ein erstes Verbindungselement (20), das eine Vielzahl erster elektrischer Anschlüsse (21, 22) aufweist und an der Kassette befestigt ist, und ein zweites Verbindungselement (25) aufweisen, das eine Vielzahl zweiter elektrischer Anschlüsse (30, 31) aufweist und an der Schaltungsanordnung der Maschine befestigt ist, dadurch gekennzeichnet, daß das Speicherelement (17) ein statischer Speicher für Daten und Programme der Schreibmaschine ist, der durch eine Sicherstellungs-Batterie (18) in der erwähnten Kassette zu einem permanenten gemacht ist, daß die elektrischen Anschlüsse der Kassette (11) eine Vielzahl von Paaren gegeneinanderwirkender, auseinanderliegender leitender Federn (21, 22) aufweisen, die alle in einem Hohlraum (24) in der Kassette aufgenommen sind und sich in Richtung auf die Öffnung des Hohlraums erstrecken, wobei die Federn miteinander fluchtende freie Kontaktenden aufweisen, daß das zweite Verbindungselement (25) einen vorspringenden Teil (25) einer gedruckten Schaltungsplatte (14) aufweist, auf der die Schaltungsanordnung der Schreibmaschine angebracht ist, wobei der vorspringende Teil (25) eine konkave Vorderkante (26) aufweist, die durch zwei seitliche Vorsprünge (27, 28) flankiert ist, die das Einstecken des vorspringenden Teils (25) in den Verbindungshohlraum (24) erleichtern und vor einem Zwischenabschnitt des vorspringenden Teils eindringen, wobei die zweiten elektrischen Anschlüsse eine Gruppe von Datenübertragungsanschlüssen (30, 31) zum Übertragen von Daten in den und aus dem Speicher (17) und zwei Stromversorgungsanschlüsse (30a, 31a) für die Stromversorgung des Speichers, wenn die Kassette (11) in die Schreibmaschine eingesetzt ist, aufweisen, wobei jeder der Anschlüsse (30, 31; 30a, 31a) derart auf dem vorspringenden Teil (25) angeordnet ist, daß er durch eine entsprechende Feder (21, 22) kontaktiert werden kann, wenn der vorspringende Teil (25) zwischen die Federpaare eingesteckt wird, daß die Datenübertragungsanschlüsse mit ihren vorderen Enden fluchten und daß die beiden Stromversorgungsanschlüsse (30a, 31a) durch einen der seitlichen Vorsprünge (27) getragen werden und weiter vorstehen als die Datenübertragungsanschlüsse, um eine Verbindung herzustellen, bevor die Datenübertragungsanschlüsse während des Einsteckens der Kassette die Verbindung herstellen.

2. Speichermodul nach Anspruch 1, dadurch gekennzeichnet, daß die elektronische Schaltungsanordnung der Schreibmaschine mit einer Spannung versorgt wird, die höher als die Spannung der Sicherstellungs-Batterie (18) ist.

3. Speichermodul nach Anspruch 1 oder 2, dadurch gekennzeichnet, daß der Hohlraum (24), der alle Anschlüsse (21, 22, 21a, 22a) der Kassette (11) einschließt, durch einen parallelepipedförmigen Teil begrenzt ist, der im eingesetzten Zustand unter einem Hauptbehälter der Kassette liegt.

## Revendications

1. Module de mémoire auxiliaire pour une machine à écrire électronique, comportant une cassette de support (11), dans laquelle se trouve disposé un circuit électronique comprenant au moins un élément de mémoire (17) et des moyens de raccordement électrique (20) servant à raccorder la mémoire au circuit fixe de la machine, et dans lequel les moyens de raccordement électrique comprennent un premier élément de connecteur (20) qui possède une pluralité de premières bornes électriques (21, 22) et est fixé à la cassette, et un second élément de connecteur (25), qui comporte une pluralité de secondes bornes électriques (30, 31) et est fixé au circuit de la machine, caractérisé en ce que l'élément de mémoire (17) est une mémoire statique servant à mémoriser des données et des programmes de la machine à écrire et qui est rendue rémanente par une pile de secours (18) logée dans ladite cassette, en ce que les bornes électriques de la cassette (11) comportent une pluralité de couples de ressorts conducteurs (21, 22) espacés et opposés, qui sont tous logés dans une cavité (24) ménagée dans la cassette et s'étendent en direction de l'ouverture de la cavité, les ressorts comportant des extrémités de contact libres et alignées, en ce que le second élément de connecteur (25) comporte une partie saillante (25) d'une plaquette à circuits imprimés (14) sur laquelle le circuit de la machine à écrire est installé, la partie saillante (25) comportant un bord avant concave (26) flanqué de deux parties saillantes latérales (27, 28) qui facilitent l'insertion de la partie saillante (25) dans la cavité (24) du connecteur et pénètrent dans cette cavité avant une section intermédiaire de la partie saillante, les secondes bornes électriques comprenant un groupe de bornes (30, 31) de transfert de données pour réaliser le transfert de données en direction et à partir de la mémoire (17) et un couple de bornes (30a, 31a) d'alimentation en énergie pour réaliser l'alimentation en énergie de la mémoire lorsque la cassette (11) est montée dans la machine à écrire, chacune des bornes (30, 31; 30a, 31a) étant disposée sur la partie saillante (25) de telle sorte qu'elle peut être contactée par un ressort correspondant (21, 22) lorsque la partie saillante (25) est insérée entre les couples de ressorts, en ce que les bornes de transfert de données sont alignées l'une avec l'autre au niveau de leurs extrémités avant et que les couples de bornes (30a, 31a) d'alimentation en énergie sont supportés par l'une des parties saillantes latérales (27) et font saillie sur une distance plus importante que les bornes de transfert de données, pour établir une connexion avant la connexion des bornes de transfert de données pendant l'insertion de la cassette.

2. Module à mémoire selon la revendication 1, caractérisé en ce que le circuit électronique de la machine à écrire est alimenté par une tension qui est supérieure à la tension de la pile de secours (18).

3. Module de mémoire selon la revendication 1 ou 2, caractérisé en ce que la cavité (24) enserrant toutes les bornes (21, 22, 21a, 22a) de la cassette (11) est définie par une partie parallèlépipédique située, en cours d'utilisation, au-dessous d'un logement principal de la cassette.

## FIG.1

FIG.2

FIG.3

2